# EUROPÄISCHE PATENTSCHRIFT

(11) **EP 0 770 445 B1**
(45) Veröffentlichungstag und Bekanntmachung des Hinweises auf die Patenterteilung: **07.11.2001**
(21) Anmeldenummer: 96112931.9
(22) Anmeldetag: 12.08.1996
(51) Int. Cl.: B23K 9/127, B23K 9/12, B23Q 15/007

(54) **Verfahren zum Kontrollieren und Positionieren eines Strahls zum Bearbeiten von Werkstücken**
Control and positioning method of a beam or jet for machining a workpiece
Méthode de contrôle et de positionnement d'un faisceau ou d'un jet pour l'usinage d'une pièce

(30) Priorität: 06.10.1995 CH 282395
(43) Veröffentlichungstag der Anmeldung: 02.05.1997
(73) Patentinhaber: ELPATRONIC AG, 8962 Bergdietikon (CH)
(72) Erfinder: Gross, Norbert, 8422 Pfungen (CH); Helm, Heinz P., 97990 Weikersheim (DE)

(56) Entgegenhaltungen:
- DE-A- 2 608 720
- DE-C- 3 801 626
- US-A- 4 916 286
- PATENT ABSTRACTS OF JAPAN vol. 18, no. 79 (M-1557), 9.Februar 1994 & JP 05 293648 A (KAWASAKI STEEL CORP), 9.November 1993,
- PATENT ABSTRACTS OF JAPAN vol. 5, no. 206 (M-104), 26.Dezember 1981 & JP 56 122673 A (SHIN MEIWA IND CO LTD), 26.September 1981,
- PATENT ABSTRACTS OF JAPAN vol. 7, no. 211 (M-243), 17.September 1983 & JP 58 107273 A (NIHON KOUKAN KOUJI KK), 25.Juni 1983,
- PATENT ABSTRACTS OF JAPAN vol. 11, no. 333 (M-637), 30.Oktober 1987 & JP 62 114787 A (TOYOTA MOTOR CORP), 26.Mai 1987,

## Beschreibung

Die Erfindung betrifft ein Verfahren zum Kontrollieren und Positionieren eines Strahls zum Bearbeiten von Werkstükken, wobei ein erster Sensor (Nahtsuchsystem) vor dem Strahl bzw. eine Vorgabe den vom Strahl nachzufahrenden Weg bestimmt, und ein zweiter Sensor nach dem Strahl die Tätigkeit des Strahles kontrolliert, sowie eine Vorrichtung hierfür. Eine Vorrichtung mit einer Vorgabe des nachzufahrenden Weges und einem nach dem Strahl angeordneten Sensor ist aus der DE 3 801 626 C1 bekannt.

In einer Vielzahl von vor allem industriellen Bearbeitungsverfahren ist es notwendig, einen Strahl zu kontrollieren bzw. zu positionieren. Dies gilt beispielsweise für das Laserstrahl- öder Wasserstrahlschneiden. In beiden Fällen wird durch eine meist elektronische Einrichtung der Weg des Strahls vorgegeben. Der Strahl hat dann diesem Weg zu folgen. Die Schnittqualität hängt unter anderem davon ab, dass sich der Strahl exakt an die vorgegebene Route hält.

Ähnliches gilt noch in grösserem Ausmasse für ein Schweissen mit einem Strahl und insbesondere für das Laserstrahlschweissen. Allerdings kommen gerade die Vorteile von durch Laserstrahlschweissen im Stumpfstossverfahren gefertigten Blechteilen in der Grosserienproduktion, z.B. im Automobilbau als "tailored blanks" bekannt, nur dann zur Geltung, wenn die hohen Anforderungen dieses Verfahrens an geometrische Teiletoleranzen, Schnittkantenqualität und Eigenschaften der Laserstrahlung erfüllt werden.

Bei einem üblichen Fokusdurchmesser 0,2 bis 0,4 mm ist zum Erreichen einer hochwertigen Schweissverbindung eine exakte Positionierung des Laserstrahls auf eine Fügelinie zwischen den beiden zu verbindenden Werkstücken erforderlich. Die maximale Positionstoleranz sollte bei Vorliegen eines technischen Nullspalts 0,1 mm nicht überschreiten. Falls vom Schmelzbad zudem Spalten überbrückt werden müssen, ist diese Toleranz weiter einzuengen.

Die sich aufgrund mangelhafter Strahlpositionierung ausbildenden Bindefehler sind besonders kritisch bei Einschweissungen, da sie durch die breitere Nahtoberaupe verdeckt werden. Auch bei Durchschweissungen kann eine etwas verbreiterte Nahtwurzel zu nicht sichtbaren, inneren Bindefehlern führen.

Hinreichend hohe Positioniergenauigkeiten werden heute mittels optoelektronischer Sensoren oder Bildverarbeitungssystemen erreicht, welche den tatsächlichen Verlauf der Fügelinie, d.h., der Stosslinie der beiden Werkstücke vor dem Strahl als Folge von Korrekturkoordinaten direkt an die Maschinensteuerung übermitteln. Auf diese Weise kann ein Laserkopf mit Genauigkeiten von ca. 0,05 mm zur Naht orientiert werden. Ein derartiges Nahtsuchsystem ist beispielsweise in der DE-OS 43 12 241 gezeigt.

Ein grundsätzlicher Nachteil bei diesen Verfahren liegt darin, dass die Fügelinien-Suchsysteme von einer fest vorgegebenen Laserstrahlposition ausgehen müssen. Ein Bezug der gemessenen Lagekoordinaten auf die tatsächliche Strahllage ist nicht möglich. Zum Behelf wird periodisch, zumindest jedoch nach jeder Justage des Strahlenganges, ein Kalibriervorgang vorgenommen, was aber eine Produktionsunterbrechung voraussetzt. Völlig unberücksichtigt bleiben die durch thermische Wirkungen im Strahlerzeuger und der Strahlführung hervorgerufenen Lageänderungen des Laserstrahls. Die Folge ist eine Verminderung der Genauigkeit des Schweissvorganges.

Eine denkbare Lösung der Problematik könnte in einer Implementierung einer Strahllagensensorik in das bereits durch den Nahtsuchsystem vorhandene Führungssystem für den Strahl bestehen. Derartige Sensoriken sind jedoch in der Regel nicht für den On-line-Betrieb geeignet, zumindest ist mit einem erheblichen Mehraufwand zu rechnen.

Bekannt ist ferner, dass eine Schweissnaht nach dem Strahl kontrolliert wird. Dabei wird allerdings die Lage der Fügelinie nicht berücksichtigt, sondern lediglich die Qualität der Schweissnaht ermittelt.

Der vorliegenden Erfindung liegt die Aufgabe zugrunde, ein Verfahren und eine Vorrichtung der oben genannten Art anzugeben, mit denen eine laufende Kontrolle und Positonierung eines Strahls, insbesondere eines Laserstrahls und dessen Korrektur auf eine Grundposition erfolgt.

Zur Lösung dieser Aufgabe führt, dass die Vorgabe oder die Aufnahmeergebnisse des ersten Sensors über eine Soll-Lage des Strahls mit Aufnahmeergebnissen des zweiten Sensors über eine Ist-Lage des Strahls unter Berücksichtigung der geschwindigkeitsabhängigen relativen Verschiebung Strahl/ Werkstück verglichen werden und bei einer Abweichung der Ist-Lage von der Soll-Lage der Strahl auf eine Grundposition korrigiert wird.

Das bedeutet, dass durch den zweiten Sensor auch der Verlauf einer Naht, insbesondere einer Schweissnaht, nach dem Strahl ermittelt und mit dem Verlauf bzw. einem gewünschten Verlauf vor dem Strahl verglichen wird. Bevorzugt geschieht dies zusammen mit einer Qualitätskontrolle der Schweissnaht selbst.

Dieses erfindungsgemässe System ist nicht etwa auf die Herstellung einer Schweissverbindung zwischen zwei Werkstükken und hier insbesondere auf das Laserschweissen beschränkt, es kann Anwendung bei allen bahngeführten Strahlverfahren finden. Vor allem gehören hierzu auch die Schneidverfahren mit energiereicher Strahlung.

Die Lösung des Problems wird vor allem dadurch ermöglicht, dass ein bildverarbeitendes System zum Erkennen der Lage der Fügelinie ein Referenz-Koordinatensystem erzeugt. Ein zweites bildverarbeitendes System kann auf dieses Referenz-Koordinatensystem Bezug nehmen, unter der Voraussetzung, dass die bildgenerierenden Sensoriken auf einer gemeinsamen starren Montagefläche fixiert und aufeinander justiert sind.

Da ein solches zweites Sensorsystem beispielsweise in einer Laser-Schweissanlage vielfach in einer Position unmittelbar nach der Schweissposition ohnehin benötigt wird, um die automatische Kontrolle der erzeugten Nahtgeometrie vorzunehmen, ist der Aufwand für dieses zweite Sensorsystem äusserst gering. Die Anforderungen an die optische Bildaufnahme wie auch die Messrate des zweiten Sensorsystems sind vergleichbar mit denjenigen des ersten Systems zur Detektion der Fügelinie, so dass in einfacher Weise ein nahezu identischer Aufbau realisiert werden kann.

Während mit dem ersten bildverarbeitenden System also die Lage der zu schweissenden Naht fortlaufend berechnet wird, charakterisiert das nachfolgende bildverarbeitende System die gerade geschweisste Naht, auch hinsichtlich ihrer Lage im gemeinsamen Referenz-Koordinatensystem. Um eine genaue, vollständige Bildüberlagerung zu erzielen, muss bei der stationären gemeinsamen Montage von beiden Sensorköpfen lediglich die geschwindigkeitsabhängige Verschiebezeit, sei es der Werkstücke, sei es des Strahls, bekannt sein, die benötigt wird, um z.B. von einem Koordinaten-Nullpunkt des Bildfeldes des ersten Sensors in die entsprechende Lage im Bildfeld des zweiten Sensors zu gelangen. Diese Verschiebezeit ist jedoch mit marktgängigen Messsystemen einfach aufzunehmen und kann zum Abgleich der zu überlagernden Bilder herangezogen werden. Bei einer bekannten Vorschubbewegung der zu schweissenden bzw. zu schneidenden Teile ist damit eine genaue Zuordnung des Ist-Verlaufes zum Soll-Verlauf zu erreichen.

Mittels der beschriebenen Bildüberlagerung kann durch das Bildanalyseprogramm punktgenau der Auftreffpunkt des fokusierten Laserstrahls in Bezug auf die tatsächliche Lage der Fügelinie ermittelt werden. Die Kenntnis dieser Bezugsgrösse ermöglicht nun einerseits bei Berücksichtigung der bekannten Werte von Fokusdurchmesser und Nahtbreite eine direkte Aussage zur Wahrscheinlichkeit des Auftretens von inneren Bindefehlern. Andererseits kann, da die thermisch verursachte Drift der Strahlposition relativ langsame Lageänderungen erzeugt, in einfacher Weise eine Korrektur der Strahllage durchgeführt werden.

Selbstverständlich ist die vorliegende Erfindung nicht auf einen eindimensionalen Vorschub beschränkt. In gleicher Weise realisierbar ist die Überwachung und Positionierung eines Strahls auch im zwei- oder dreidimensionalen Vorschub.

Aus dem Stand der Technik ist eine Vielzahl von Verfahren zum Ermitteln des Verlaufs einer Fügelinie bzw. einer Schweissnaht bekannt. All diese Verfahren können bei der vorliegenden Erfindung Anwendung finden. Beispielhaft soll das Lichtschnittverfahren und das Verfahren mit Graubildauswertung erwähnt werden. Eine Erklärung des Lichtschnittverfahrens ist beispielsweise in der DE-OS 43 12 241 zu finden, eine Erklärung der Ermittlung der Fugengeometrie mittels Graubildauswertung findet sich in DVS-Berichte, Band 94 (1985), Seite 44 ff.

Jenachdem können die beiden Sensoren mit gleichen oder unterschiedlichen Verfahren arbeiten. Hierbei wird die Praxis zeigen, welche qualitativen Anforderungen an die einzelnen Verfahren zu stellen sind. Soll das erfindungsgemässe Verfahren beim Schneiden mittels eines Strahls angewandt werden, so erübrigt sich in den meisten Fällen der dem Strahl vorlaufende Sensor. Hier übernimmt die in einem elektronischen Speicher vorhandene Vorgabe die Aufgabe des Sensors zur Bestimmung der Soll-Lage und auch die entsprechende Führung des Strahls.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in
Figur 1 eine teilweise blockschaltbildlich dargestellte Draufsicht auf eine Vorrichtung zum Kontrollieren und Positionieren eines Strahls zum Bearbeiten von Werkstücken;
Figur 2 eine Draufsicht auf die Vorrichtung gemäss Figur 1 mit schematisch dargestellter Ermittlung der Position des Strahls.

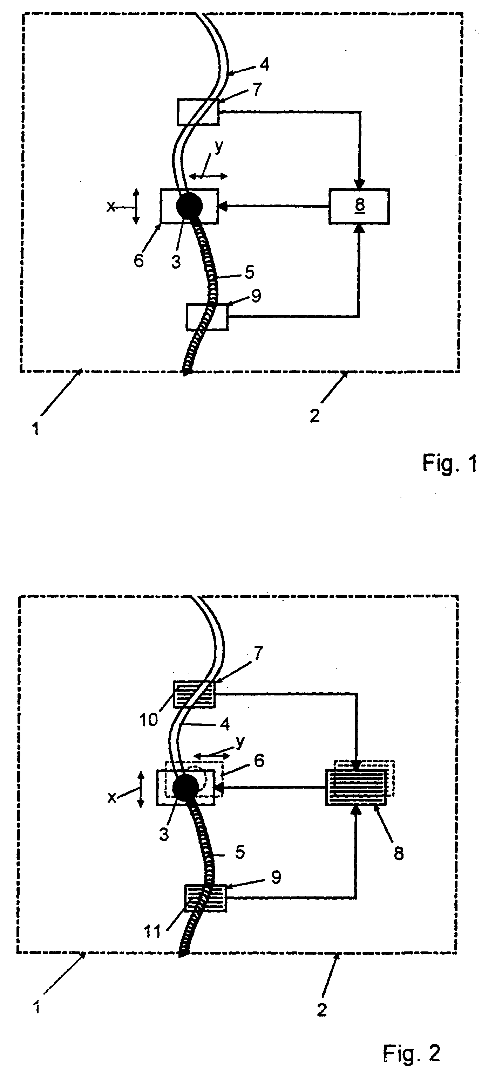

Gemäss Figur 1 sollen zwei Werkstücke 1 und 2 miteinander durch einen Strahl 3 verbunden werden. Der Bereich der Verbindung zwischen den beiden Werkstücken 1 und 2 vor dem Strahl 3 wird als Fügelinie 4, der Bereich nach dem Strahl 3 als Schweissnaht 5 bezeichnet.

Der Strahl 3 kommt von einer nicht näher gezeigten Strahlquelle an einer Verschiebeeinrichtung 6, welche beispielsweise aus einem Kreuzschlitten bestehen kann. In diesem Fall ist die Verschiebeeinrichtung 6 zweidimensional in Richtung x bzw. y verschiebbar. Denkbar ist allerdings auch eine dreidimensionale Verschiebbarkeit. Wesentlich allein ist, dass durch die Verschiebeeinrichtung 6 der Strahl 3 entlang der Fügelinie 4 und auf diese ausgerichtet geführt werden kann.

Damit der Strahl 3 entlang der Fügelinie 4 geführt werden kann, ist dem Strahl 3 ein Sensor 7 vorgeschaltet, der auch als Nahtsuchsystem bezeichnet wird. Mit diesem Sensor 7 wird der Verlauf der Fügelinie 4 laufend ermittelt und anhand der geschwindigkeitsabhängigen Verschiebezeit der Werkstücke - oder der Verschiebezeit des Strahls, falls dieser gegenüber den Werkstücken verschoben wird - der Verlauf der Fügelinie 4 über eine Steuereinheit 8 ermittelt, wobei diese Steuereinheit 8 die Verschiebeeinrichtung 6 entsprechend den Messergebnissen des Sensors 7 in Bewegung setzt, so dass der Strahl 3 immer genau auf die Fügelinie 4, bevorzugt auf eine nicht näher dargestellte Mittellinie der Fügelinie 4, gerichtet ist.

Erfindungsgemäss soll dem Strahl 3 ein weiterer Sensor 9 nachgeschaltet sein, der ebenfalls mit der Steuereinheit 8 in Verbindung steht. Dieser zweite Sensor 9 beobachtet die Schweissnaht 5.

Die Funktionsweise der vorliegenden Erfindung soll insbesondere beispielhaft anhand von Figur 2 beschrieben werden:

Der Sensor 7, der dem Strahl 3 vorläuft, arbeitet dabei im sogenannten Lichschnittverfahren. Dabei wird schräg zur optischen Achse der Sensoroptik ein Streifenmuster, im vorliegenden Fall aus fünf parallelen Streifen 10 bestehend, auf den Bereich der Fügelinie 4 projiziert. Dabei verlaufen die Streifen 10 im wesentlichen quer zur Schweissnaht, können aber auch unterschiedlich beabstandet sein. Im Bereich der Fügelinie 4 werden die Streifen unterbrochen, oder es finden Versetzungen statt, die von der Sensoroptik erkannt werden. Ein Verlauf der Fügelinien kann dann anhand einer der Streifenzahl entsprechenden Anzahl von Punkten bestimmt werden.

Gemäss Figur 2 arbeitet nach demselben Prinzip auch der zweite Sensor 9, wobei hier die Schweissnaht 5 mit entsprechendem Streifenmuster 11 ausgeleuchtet wird.

Weicht nun der Strahl 3 im Laufe der Zeit beispielsweise durch eine thermisch verursachte Drift von seiner durchgezogen gezeigten Position in eine gestrichelt angedeutete Position ab, so kann dies durch den Sensor 7 nicht festgestellt werden, da dieser Sensor 7 immer davon ausgeht, dass der Strahl 3 sich in Grundposition befindet. Dagegen ermittelt aber der nachfolgende Sensor 9 einen von dem vom Sensor 7 abweichenden Verlauf der Schweissnaht 5, da die der Steuereinheit 8 zugeleiteten Messergebnisse, die beispielsweise aus durch Bildanalysen gewonnenen Lagekoordinaten bestehen, nicht mehr übereinstimmen. Dies ist ebenfalls schematisch gestrichelt angedeutet. Mittels der Steuereinheit 8 wird nun die Verschiebeeinheit entsprechend dem erhaltenen Korrekturwert bewegt, so dass der Strahl 3 wieder in die Grundposition gefahren wird.

## Patentansprüche

1. Verfahren zum Kontrollieren und Positionieren eines Strahls (3) zum Bearbeiten von Werkstücken, wobei ein erster als Nachtsuchsystem ausgebildeter Sensor (7) vor dem Strahl bzw. eine Vorgabe den vom Strahl (3) nachzufahrenden Weg bestimmt und ein zweiter Sensor (9) nach dem Strahl (3) die Tätigkeit des Strahls kontrolliert,
**dadurch gekennzeichnet,**
**dass** die Vorgabe oder Aufnahmeergebnisse des ersten Sensors (7) über eine Soll-Lage des Strahls (3) mit Aufnahmeergebnissen des zweiten Sensors (9) über eine Ist-Lage des Strahls (3) unter Berücksichtigung der geschwindigkeitsabhängigen relativen Verschiebung Strahl/Werkstück verglichen werden und bei einer Abweichung der Ist-Lage von der Soll-Lage der Strahl (3) auf eine Grundposition korrigiert wird.

2. Verfahren zum Kontrollieren und Positionieren eines Strahls (3) zum Bearbeiten von Werkstücken nach Anspruch 1,
**dadurch gekennzeichnet, dass** die Soll-Lage des Strahls (3) in einem Lichtschnittverfahren oder einer Kombination aus Lichtschnitt- und Graubildauswertungsverfahren und die Ist-Lage des Strahls (3) in einem Graubildauswertungsverfahren oder einer Kombination aus Lichtschnitt- und Graubildauswertungsverfahren ermittelt und miteinander verglichen werden.

3. Vorrichtung zum Kontrollieren und Positionieren eines Strahls (3) zum Bearbeiten von Werkstücken, wobei ein erster als Nachtsuchsystem ausgebildeter Sensor (7) vor dem Strahl bzw. eine Vorgabe den vom Strahl (3) nachzufahrenden Weg bestimmt und ein zweiter Sensor (9) nach dem Strahl (3) die Tätigkeit des Strahls kontrolliert, **dadurch gekennzeichnet, dass** der erste Sensor oder die Vorgabe und der zweite Sensor (7,9) mit einer Steuereinheit (8) zum Vergleichen der Aufnahmeergebnisse beider Sensoren (7, 9), bzw. der Vorgabe mit dem Aufnahmeergebnis des zweiten Sensores verbunden sind, wobei die Steuereinheit (8) mit einer Verschiebeeinrichtung (6) für eine relative Verschiebebewegung von Strahl (3) zum Werkstück verbunden ist.

## Claims

1. Method for monitoring and positioning a beam (3) for operating on workpieces, in which a first sensor (7) constructed as a seam detecting system before the beam, and/or a preset value, determines the path to be followed by the beam (3), and a second sensor (9) after the beam (3) monitors the action of the beam,
**characterized in that**
the preset value or the readings obtained by the first sensor (7) of a required position of the beam (3) is or are compared with readings obtained by the second sensor (9) of an actual position of the beam (3) taking account of the velocity-dependent relative displacement between the beam and the workpiece, and the beam (3) is corrected to a basic position if the actual position deviates from the required position.

2. Method for monitoring and positioning a beam (3) for operating on workpieces according to Claim 1, **characterized in that** the required position of the beam (3) is detected by a light-slit method or a combination of light-slit and grey-level image analysis techniques and the actual position of the beam (3) is detected by a grey-level image analysis technique or a combination of light-slit and grey-level image analysis techniques and [the required and actual positions of the beam (3)] are compared with one another.

3. Apparatus for monitoring and positioning a beam (3) for operating on workpieces, in which a first sensor (7) constructed as a seam detecting system before the beam, and/or a preset value, determines the path to be followed by the beam (3) and a second sensor (9) after the beam (3) monitors the action of the beam, **characterized in that** the first sensor (7) or the preset value and the second sensor (9) are connected to a control unit (8) for comparing the readings obtained by the two sensors (7, 9) or as the case may be for comparing the preset value with the reading obtained by the second sensor, the said control unit (8) being connected to a translation device (6) for relative displacement of the beam (3) with respect to the workpiece.

## Revendications

1. Procédé pour contrôler et positionner un faisceau (3) pour le façonnage de pièces, selon lequel un premier capteur (7) agencé sous la forme d'un système de suivi de cordon, situé en avant du faisceau, ou une prescription détermine le trajet devant être suivi par le faisceau (3), et un second capteur (9) situé en arrière du faisceau (3) contrôle l'activité du faisceau,
**caractérisé en ce que** la prescription ou les résultats d'enregistrement du premier capteur (7) concernant une position de consigne du faisceau (3) est comparée à des résultats d'enregistrement du second capteur (9) concernant une position réelle du faisceau (3) en tenant compte du déplacement relatif faisceau/pièce, qui dépend de la vitesse, et le faisceau (3) est corrigé en étant réglé sur une position de base dans le cas d'un écart entre la position réelle et la position de consigne.

2. Procédé pour contrôler et positionner un faisceau (3) pour le façonnage de pièces selon la revendication 1, **caractérisé en ce que** la position de consigne du faisceau (3) est déterminée selon un procédé d'interruption de lumière ou au moyen d'une combinaison d'un procédé d'interruption de lumière et d'un procédé d'exploitation d'une image de gris et la position réelle du faisceau (3) est déterminée selon un procédé d'exploitation d'une image de gris ou bien au moyen d'une combinaison d'un procédé d'interruption de lumière et d'un procédé d'exploitation d'une image de gris, et la position de consigne et la position réelle sont comparées entre elles.

3. Procédé pour contrôler et positionner un faisceau (3) pour le façonnage de pièces, dans lequel un premier capteur (7) agencé en tant que système de suivi de cordon, situé en avant du faisceau, ou une prescription détermine le trajet devant être suivi par le faisceau (3), et un second capteur (9) situé en arrière du faisceau (3) contrôle l'activité du faisceau, **caractérisé en ce que** le premier capteur ou la prescription et le second capteur (7, 9) sont reliés à une unité de commande (8) servant à comparer les résultats d'enregistrement des deux capteurs (7, 9) ou à comparer la prescription au résultat d'enregistrement du second capteur, l'unité de commande (8) étant reliée à un dispositif de translation (6) pour un mouvement relatif de translation du faisceau (3) par rapport à la pièce.
